# EUROPÄISCHE PATENTSCHRIFT

(11) **EP 1 082 224 B1**
(45) Veröffentlichungstag und Bekanntmachung des Hinweises auf die Patenterteilung: **11.02.2004**
(21) Anmeldenummer: 99948856.2
(22) Anmeldetag: 24.09.1999
(51) Int. Cl.: B41C 1/10, B41N 1/00

(54) **DRUCKFORM UND VERFAHREN ZUM ÄNDERN IHRER BENETZUNGSEIGENSCHAFTEN**
PRINTING MOULD AND METHOD FOR MODIFYING ITS WETTING CHARACTERISTICS
FORME D'IMPRESSION ET PROCEDE PERMETTANT DE MODIFIER SES CARACTERISTIQUES DE MOUILLAGE

(30) Priorität: 10.10.1998 DE 19846808
(43) Veröffentlichungstag der Anmeldung: 14.03.2001
(73) Patentinhaber: Heidelberger Druckmaschinen Aktiengesellschaft, 69115 Heidelberg (DE)
(72) Erfinder: HESS, Peter, D-69121 Heidelberg (DE)
(86) Internationale Anmeldenummer: PCT/EP1999/007119
(87) Internationale Veröffentlichungsnummer: WO 2000/021753

(56) Entgegenhaltungen:
- EP-A- 0 262 475
- EP-A- 0 542 061
- DE-A- 4 442 235
- DE-C- 4 235 242
- US-A- 3 678 852

## Beschreibung

Die Erfindung betrifft ein Verfahren zum Ändern der Benetzungseigenschaften einer Druckform mit einer Halbleiteroberfläche, sowie eine Druckform mit einer Halbleiteroberfläche, die unterschiedliche Benetzungseigenschaften aufweist, und deren Verwendung in einem Offsetdruckprozeß.

Aus der EP 262 475 B 1 ist bereits eine Druckmaschine bekannt, die mit einer Druckform ausgestattet ist, auf der ein zu druckendes Bild durch entsprechende hydrophobe und hydrophile Bereiche darstellbar ist. Um eine Umschaltung zwischen dem hydrophilen bzw. hydrophoben Zustand in den einzelnen Bereichen zu ermöglichen, wird auf der Druckform ferroelektrisches Material vorgesehen, das örtlich polarisierbar bzw. depolarisierbar ist. Die Hydrophilierung bzw. Umhydrophilierung der Druckform erfolgt dementsprechend durch einen Polarisier- bzw. Depolarisiermechanismus, der innerhalb der Druckmaschine reversibel durchführbar ist. Nachteilig an diesem Verfahren ist allerdings, daß der Effekt auf weitreichend elektrostatischen Anziehungskräften beruht und dementsprechend die Auflösung des zu druckenden Bildes durch die weitreichenden elektrischen Anziehungskräfte begrenzt ist.

Aus der US-PS 3,678,852 ist darüber hinaus eine Druckplatte bekannt, die mit einem amorphen Halbleiter beschichtet ist. Der amorphe Zustand des Halbleiters läßt sich mit Hilfe eines Laserstrahls von dem ungeordneten amorphen Zustand in einen höher geordneten kristallinen Zustand verändern. Im kristallinen Zustand ist die Halbleiteroberfläche rauher, so daß die Umordnung der Halbleiteroberfläche dazu führt daß Flüssigkeiten im Bereich der rauheren Oberfläche besser haften als in den amorphen glatten Bereichen. Die Auflösung der Druckplatte, die gemäß diesem Verfahren hergestellt wird, ist durch die Mindestgröße der kristallinen Bereiche beschränkt.

Aufgabe der vorliegenden Erfindung ist es, ein alternatives Verfahren zum lokalen und wiederholten Ändern der Benetzungseigenschaften einer Druckform mit einer Halbleiteroberfläche zu schaffen sowie eine entsprechende Druckform vorzuschlagen.

Diese Aufgabe wird durch die Merkmale gemäß den Ansprüchen 1 und 11 gelöst.

Der Grundgedanke der vorliegenden Erfindung besteht darin, das lokale Benetzungsverhalten, also das lokale hydrophile bzw. hydrophobe Verhalten einer Druckform über die Kontrolle der chemischen Endgruppen der Oberfläche mit entsprechend unterschiedlichen elektronischen Eigenschaften, d. h. Wechselwirkungseigenschaften zu verändern. Hierzu wird zunächst eine Oberfläche mit einer chemischen Struktur erzeugt, die eine bevorzugt im wesentlichen einheitliche hydrophile oder hydrophobe Benetzungseigenschaft aufweist. Diese Oberfläche wird dann in örtlich begrenzten Teilflächen durch eine lokal begrenzte Änderung der chemischen Struktur in den jeweils anderen Zustand der Benetzungseigenschaft, also von hydrophil nach hydrophob bzw. von hydrophob nach hydrophil übergeführt. Bei diesem chemischen Umschaltprozeß ist es nicht erforderlich, spezielle ferromagnetische Materialien einzusetzen oder eine Änderung der Oberflächenrauhigkeit, beispielsweise durch Kristallisierung, hervorzurufen. Vielmehr wird das Benetzungsverhalten in den einzelnen Bereichen der Halbleiteroberfläche dadurch gesteuert, daß die Halbleiteroberfläche gezielt mit hydrophilen und hydrophoben chemischen Endgruppen versehen wird.

Dieser lokalisierte Umschaltprozeß kann beispielsweise mit Hilfe des sogenannten chemischen Processings erfolgen, bei dem mittels photothermischer, photochemischer oder generell mittels laserinduzierter Reaktionsprozesse die chemische Umwandlung erfolgt.

In einer bevorzugten Ausführungsform wird Silizium als Halbleiter gewählt. Diese Halbleiteroberfläche wird zunächst in einem hydrophoben Zustand versetzt, wobei in die Oberfläche beispielsweise SiH-, SiH₂- und/oder SiH₃-Gruppen eingebracht oder an sie angelagert werden. Zur Änderung des hydrophoben Verhaltens wird dann lokal die hydrophobe Atomgruppe durch eine hydrophile Atomgruppe ausgetauscht oder in eine solche umgewandelt, so daß beispielsweise SiOH-, SiOSi- und/oder SiO- Einheiten die hydrophoben Gruppen ersetzen.

Bei Verwendung einer Silizium (111)-Oberfläche als Oberfläche der Druckform ergibt sich dabei der besondere Vorteil, daß die Oberfläche atomar glatt und die hydrophilen bzw. hydrophoben Endgruppen im wesentlichen in gleichen Abständen zueinander angelagert werden können.

Für die Erzeugung einer hydrophilen bzw. hydrophoben Ausgangsschicht und den Umschaltvorgang zwischen hydrophil und hydrophob kommen unterschiedliche Prozesse in Betracht.

So kann z. B zur Herstellung einer einheitlichen hydrophilen Oberfläche die Druckform einem geeigneten naßchemischen Modifizierungsprozess unterzogen werden, wodurch sich unter geeigneten Bedingungen eine stark hydrophile Benetzbarkeit der Oberfläche erzeugen läßt, die beispielsweise dadurch verursacht wird, daß in den ersten Atomlagen der Halbleiteroberfläche SiOH- und/oder SiO- Gruppen eingebaut werden. Durch Bestrahlung mit einem Laser geeigneter Wellenlänge, insbesondere mit einem gepulsten Laser, läßt sich diese hydrophile Benetzungseigenschaft nun gezielt und lokal in eine hydrophobe ändern, indem die hydrophilierende Atomgruppe durch eine hydrophobe Oberflächenkonfiguration ersetzt wird.

Aber auch ein umgekehrt ablaufender Prozeß ist möglich. Dabei wird zunächst eine im wesentlichen hydrophobe Oberfläche der Druckform erzeugt wird. Hierzu kann beispielsweise die Druckform mit einer verdünnten HF-Lösung oder einer Fluorid-Ammonium Lösung behandelt werden, wobei nur die obersten Schichten des Halbleiters abgetragen werden und eine hydrophobe, wasserstoffterminierte Oberfläche entsteht. Diese kann dann in einzelnen Bereichen wieder hydrophiliert werden, wobei diesen Bereichen lokal Energie zugeführt wird.

Nach der Verwendung der Druckform, also nach dem Drucken, kann die gesamte Oberfläche wieder in den Ausgangszustand versetzt werden. Anschließend steht die Druckform für eine neue Bebilderung zur Verfügung.

Mit dem erfindungsgemäßen Verfahren gelingt es, eine Druckform zu schaffen, die zum einen wiederholt bebilderbar und damit in vielen aufeinander folgenden Zyklen wieder verwendbar ist. Darüber hinaus ist die Auflösung der Druckform nicht durch die Größe der Kristalle oder eine elektrische Wechselwirkung begrenzt.

Weitere Vorteile und vorteilhafte Weiterentwicklungen sind Gegenstand der nachfolgenden Figuren sowie deren Beschreibungen.

Es zeigen im einzelnen:
- Fig. 1: die schematische Darstellung des erfindungsgemäßen Verfahrens,
- Fig. 2: eine Prinzipdarstellung der Änderung einer Halbleiteroberfläche von hydrophil nach hydrophob am Beispiel der Endgruppen SiH- und SiOH.

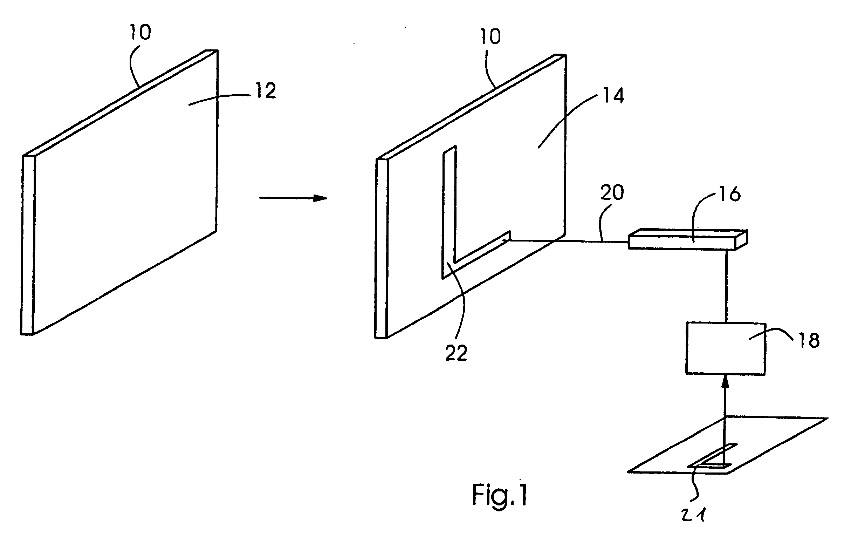

Wie in Fig. 1 gezeigt, ist der Ausgangspunkt des erfindungsgemäßen Verfahrens eine Druckform 10, die wie in Fig. 1 gezeigt, als Druckplatte oder auch als Druckzylinder ausgeführt sein kann. Die Druckform 10 weist eine Oberflächenschicht 12 eines Halbleiters, insbesondere Silizium, auf, die auf die Druckform aufgebracht ist. Diese Ausgangsdruckform ist nach ihrem Herstellungsprozeß üblicherweise mit einer nativen, d. h. nicht genau definierten Oxidschicht bedeckt, deren Dicke 1 bis 3 nm üblicherweise beträgt.

In einem ersten erfindungsgemäßen Verfahrensschritt wird diese Druckform in eine Druckform mit einer definierten im wesentlichen hydrophoben Oberflächenschicht 14 übergeführt. Die Oberflächenschicht 12 der Druckform 10 wird zu diesem Zweck wasserstoffterminiert. Es werden also die freien Valenzen z. B. der Siliziumoberflächenatome mit Wasserstoff abgesättigt. Je nach Kristallfläche, die an der Oberfläche des Halbleiters vorliegt, kann der Halbleiter, der bevorzugt Silizium ist, ein oder mehrere Wasserstoffatome binden. Im Falle der (11 1)-Silziumkristallfläche wird entsprechend an jedes Siliziumatom senkrecht zur (111)-Oberfläche ein Wasserstoffatom angelagert. Im Falle der (001)- oder anderer Kristallflächen des Siliziums können pro Siliziumatom an der Oberfläche mehrere freie Valenzen vorliegen, so daß zwei oder mehr Wasserstoffatome an das Siliziumoberflächenatom angelagert werden können. Da die polykristalline Siliziumoberfläche aus einer Mischung aus verschiedenen Kristalloberflächen - (111), (101) oder anderen - besteht, folgt daraus, daß die polykristalline bzw. amorphe Halbleiteroberfläche eine Mischung aus Mono-, Di- und Tri-Hydride aufweist.

Der oben beschriebene Wasserstoffterminierungsprozeß zur Erzeugung einer hydrophoben Halbleiteroberfläche läßt sich beispielsweise durch eine Behandlung der Oberfläche mit einer verdünnten HF-Lösung oder einer gepufferten Ammoniumfluorid Lösung erzeugen, wobei nur die obersten Schichten des Halbleiters in atomarer Dimension bis zu weinigen Nanometern abgetragen werden und die oben beschriebene hydrophobe Hydridschicht entsteht.

Während bei einem Einkristall entlang der Si(111)-Ebene die Anwendung einer gepufferten NH₄F-Lösung (pH ≈ 8) wegen des anisotropen Ätzprozesses zu einer weiteren Einebnung, d. h. zu einer atomar ebenen Oberfläche führt, die im Idealfall nur noch atomare Stufen aufweist, wird bei einer polykristallinen Siliziumoberfläche die mikroskopische Rauhigkeit durch den anisotropen Ätzprozess erhöht. Mit einer verdünnten HF-Lösung hingegen wird bei einer polykristallinen Siliziumoberfläche nur die Oxidschicht abgetragen, die mikroskopische Rauhigkeit also nicht verändert. Nach diesem Vorgang weist die Druckform 10 also eine hydrophobe Oberfläche 14 auf, die für das weitere erfindungsgemäße Verfahren verwendbar ist.

Die hydrophobe Oberfläche 14 der Druckform 10 wird nun in einem weiteren Verfahrensschritt in Teilbereichen seiner Oberfläche hydrophiliert. Dies kann beispielsweise dadurch erfolgen, daß die zu hydrophilierenden Oberflächenbereiche lokal einer chemischen Umformung unterzogen werden und damit die Oberfläche lokal dehydriert und die dehydrierten Stellen der Oberfläche mit hydrophilen Atomgruppen besetzt werden. Für eine lokale Modifizierung der Oberfläche haben sich zwei Verfahren als besonders geeignet herausgestellt. Wie in Fig. 1 gezeigt, kann die lokale Energiezuführung und Prozessauslösung beispielsweise über einen Laser 16 erfolgen. Besonders geeignet sind dabei gepulste Laser, die einen niedrigen Strahlquerschnitt aufweisen, so daß die Dehydrierung in einem räumlich begrenzten Bereich durchgeführt werden kann. Als Laser kann beispielsweise ein VUV-Flourlaser mit einer Wellenlänge von 157 nm verwendet werden, wenn die Oberflächenmodifikation photochemisch durchgeführt werden soll.

Für eine photothermische Modifikation, die je nach Hydrid eine lokale Erwärmung auf 300 - 550° C erfordert, kommen im Prinzip alle UV-Laser in Frage, wie z. B. Gaslaser (Excimer-Laser) und Festkörperlaser (z. B. frequenzvervielfachte Nd: YAG-Laser).

Diese Laser werden üblicherweise durch eine Steuereinheit 18 gesteuert, mit deren Hilfe der Strahl 20 des Lasers 16 über die Druckform geführt, dabei ein- und ausgeschaltet oder ein- und ausgeblendet wird, so daß ein zu druckendes Muster 22 oder das Negativ des Musters als hydrophiles Bild in einer ansonsten hydrophoben Oberfläche 14 eingebracht werden kann. Mit bloßem Auge ist diese molekulare Eigenschaftsänderung auf der Oberfläche der Druckform normalerweise nicht zu erkennen. Das aufgebrachte Druckbild 22 entspricht üblicherweise einem Vorlagenbild 21, das auf unterschiedliche Weise erzeugt werden kann. So kommen dabei alle bekannten Digitalisierungsverfahren einer Vorlage sowie die direkte digitale Erzeugung des Bildes, beispielsweise mit Hilfe eines Grafikprogrammes oder einer digitalen Kamera, in Frage.

Üblicherweise werden diese Bilder dann in einem sogenannten RIP (Raster Imaging Processor) gespeichert, wobei dieser Speicher in der Steuerungseinheit 18 oder außerhalb liegen kann. Basierend auf den im RIP gespeicherten Daten wird dann der Laserstrahl 16 so gesteuert, daß das Bild 22 auf der Druckform 10 aufgebracht wird. Neben dieser Bebilderung durch das lokale Zuführen von Energie mit Hilfe eines Lasers ist es auch möglich, die Energie breitflächiger etwa mit einer Lampe, wie beispielsweise einer UV-Lampe (insbesondere kommerziell verfügbaren Excimer-Lampen mit verschiedenen UV-Wellenlängen) aufzubringen. Besonders vorteilhaft ist es dabei, vor dem Bestrahlen der Druckform die Druckform mit einer Maske zu belegen, so daß lediglich an bestimmten Bereichen die Lampe ihre Wirkung auf der Oberfläche 14 der Druckform 10 entfalten kann.

Mit Hilfe beider Verfahren läßt es sich dementsprechend erreichen, daß auf der hydrophoben Oberfläche 14 der Druckform 10 durch einen lokalen photoindizierten Reaktionsprozess in Teilbereichen ein veränderter, zweiter chemischer Zustand erzeugt wird, der hydrophil ist.

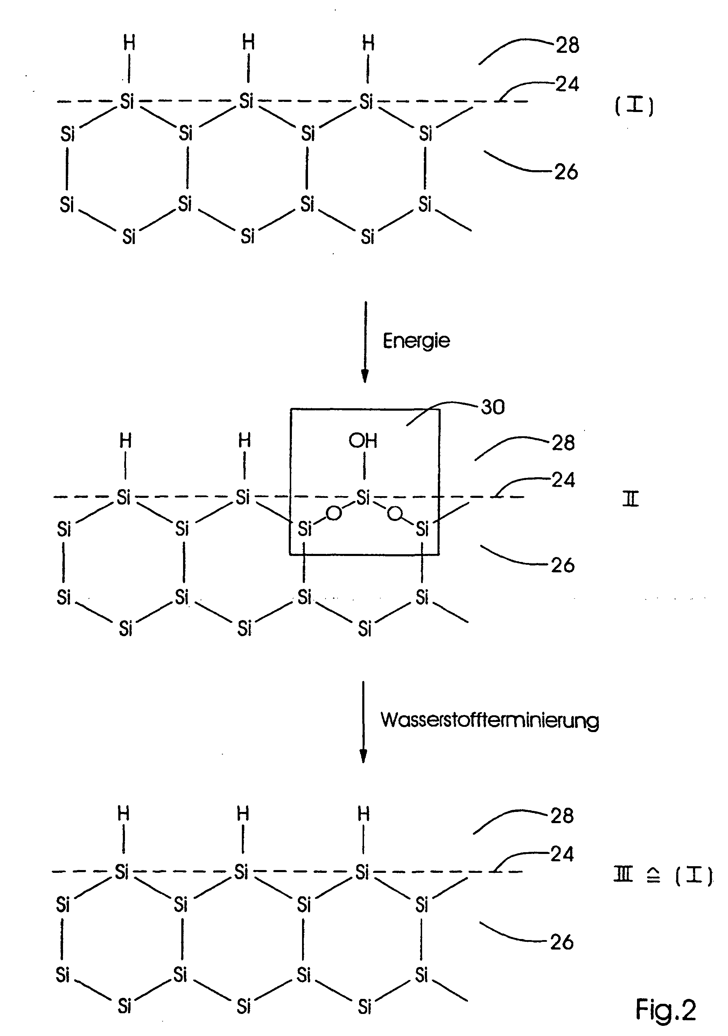

In Fig. 2 ist schematisch und idealisiert die Strukturformel eines Siliziumhalbleiterfestkörpers an der Oberfläche 24 gezeigt, wobei im Idealfall die Trennlinie 24 den Festkörperbereich 26 von dem Bereich 28 außerhalb des Festkörpers trennt. Jedes Silizium-Atom, das an der Oberflächenlinie 24 liegt, weist eine freie Valenz auf, die im Falle der wasserstoffterminierten Oberfläche des Silizumhalbleiters monohydriert, d. h. also mit einem Wasserstoffatom abgesättigt ist. Durch einen photoinduzierten Prozess wird dieser Oberflächenzustand im Bereich 30 dehydriert und in einen zweiten chemischen Zustand umgewandelt, der hydrophil ist. Dieser hydrophile Zustand zeichnet sich zum eine durch einen außerhalb der Grenzlinie 24 des Halbleiters liegende hydrophile Atomgruppe, im vorliegenden Fall OH, aus. Daneben ist es auch möglich, daß im Oberflächenbereich in einer oder mehreren Atomlagen des Halbleiters 26 Sauerstoffatome eingelagert werden, so daß die hydrophile Benetzungseigenschaft in diesen Bereichen noch weiter verstärkt wird. Eine so behandelte Oberfläche einer Druckform weist also erste chemische Zustände auf, die hydrophob sind und zweite chemische Zustände, die hydrophil sind. Durch dieses unterschiedliche Anziehungsverhalten im Hinblick auf Wasser läßt sich die Druckform für den Offsetdruck verwenden.

Nach dem Drucken wird die an der Oberfläche 28 des Halbleiters angelagerte Farbe durch übliche Farbabwaschprozesse entfernt, wobei es besonders leicht ist, diese Druckfarbe zu entfernen, da bei dem erfindungsgemäß vorgeschlagenen Verfahren nur mikroskopische Rauhigkeiten in die Oberfläche eingebracht werden, und der Unterschied zwischen hydrophob und hydrophil aufgrund der chemischen Zusammensetzung der Oberfläche sowie der unmittelbar unter der Oberfläche liegenden modifizierten Bereiche erzeugt werden. Sobald die Druckfarbe von der Oberfläche der Druckform entfernt ist, kann die Druckform wieder in ihren ursprünglichen hydrophoben Zustand versetzt werden, indem die Oberfläche einer Behandlung unterzogen wird, die diese wieder wasserstoffterminiert, so daß der ursprüngliche Zustand (I) wieder erreicht wird. Dies kann beispielsweise dadurch erfolgen, daß von der Oberfläche, wie in Figur 2 (II) dargestellt, Bereiche in atomarer Größenordnung (wenige Monolagen) abgetragen werden und somit wieder eine reine Silizium-Oberfläche entsteht, die leicht mit Wasserstoffatomen abgesättigt werden kann.

Als eines der chemische anwendbaren Verfahren kommt dabei beispielsweise die Behandlung der Oberfläche mit einer Ammonium-Chlorid HF-Lösung in Betracht, wobei mit Hilfe dieses Verfahrens die oberste Schicht abgetragen und gleichzeitig die Wassestoffterminierung der Oberfläche erfolgt.

Das in Fig. 2 gezeigte Verfahren bezieht sich auf eine Silizium-Oberfläche, bei der die (111)-Kristall-Ebene an der Oberfläche des Siliziumfestkörpers liegt. Selbstverständlich ist es auch möglich, daß die Oberfläche polykristallin ist, daß an der Oberfläche also eine Mischung aus verschiedenen Kristallebenen vorliegt. Damit können die hydrophoben Eigenschaften verstärkt werden. Insbesondere werden dabei z. B. die (001) und andere Kristallflächen an der Oberfläche des Siliziumfestkörpers auftreten, so daß zusätzliche freie Valenzen durch weitere Wasserstoffatome abgesättigt werden können.

Neben dem bereits beschriebenen naßchemischen Prozeß zur Wasserstoffterminierung kommen auch alle anderen Verfahren in Betracht, die eine im wesentlichen vollständige Wasserstoffterminierung oder Alkylierung der Siliziumhalbleiteroberfläche hervorrufen.

Die bislang beschriebene erfindungsgemäße Vorgehensweise ist darauf gerichtet, daß eine hydrophobe Ausgangsoberfläche lokal hydrophiliert wird. Erfindungsgemäß ist jedoch auch die umgekehrte Vorgehensweise möglich, bei der eine hydrophile Oberfläche durch einen lokalen photoinduzierten Prozess in diesen Bereichen hydrophob wird. Um dies zu erreichen, wird zunächst eine hydrophile Oberfläche zu erzeugt, was beispielsweise dadurch geschehen kann, daß die Druckform naßchemisch mit H₂O₂ behandelt wird. Eine weitere Möglichkeit besteht in der laserinduzierten Oxidation in feuchter Atmosphäre.

Durch Bestrahlung mit einem Laser im Beisein von Alkohol (z B. CH₃OH) werden die OH-Gruppen von der Oberfläche entfernt. Dabei entstehen neben SiH- auch hydrophobe SiCH₃- SiOCH₃-Gruppen. Dadurch wird die Druckform an den bestrahlten Flächen hydrophob gegenüber Wasser und ist somit für den Druckprozess geeignet.

Neben dem beschriebenen Silizium als Halbleiter sind auch Germanium oder eine Legierung, die Germanium und Silizium enthält (SiGe) aber auch SiC oder SiCN, verwendbar.

Das vorgeschlagene Verfahren läßt sich innerhalb sowie außerhalb der Druckmaschine anwenden, so daß sich für viele Anwendungsgebiete des Offsetdrucks der große Vorteil ergibt, daß die Druckform wiederverwendbar ist. Insbesondere beim Einsatz des Verfahrens innerhalb einer Druckmaschine ergibt sich ein wesentlicher zeitlicher Vorteil, da die Druckform nicht ausgebaut werden muß.

## Patentansprüche

1. Verfahren zum Ändern der Benetzungseigenschaften einer Druckform (10) mit einer Halbleiteroberfläche (12),
**dadurch gekennzeichnet,**
- **dass** die Oberfläche des Halbleiters in einen ersten chemischen Zustand mit einem ersten Benetzungsverhalten gebracht wird,
- eine Teilmenge aller Bereiche der Halbleiteroberfläche in einen zweiten chemischen Zustand mit einer zweiten Benetzungseigenschaft durch eine Änderung der chemischen Endgruppen der Halbleiteroberfläche gebracht wird, wobei diese zweite Benetzungseigenschaft von der ersten Benetzungseigenschaft verschieden ist.

2. Verfahren nach Anspruch 1,
**dadurch gekennzeichnet,**
**dass** der zweite chemische Zustand durch eine Änderung von Atomgruppen der ersten atomaren Schichten im Oberflächenbereich des Halbleiters erreicht wird.

3. Verfahren nach einem der Ansprüche 1 oder 2,
**dadurch gekennzeichnet,**
**dass** die erste Benetzungseigenschaft hydrophil und die zweite Benetzungseigenschaft hydrophob oder die erste Benetzungseigenschaft hydrophob und die zweite Benetzungseigenschaft hydrophil ist.

4. Verfahren nach einem der Ansprüche 1 bis 3,
**dadurch gekennzeichnet,**
**dass** der erste chemische Zustand durch einen Schichtabbau an der Oberfläche des Halbleiters in atomarer Dimension, bevorzugt mit HF oder einer Ammoniumflourid-(AF-) Lösung erzeugt wird.

5. Verfahren nach einem der Ansprüche 1 bis 4,
**dadurch gekennzeichnet,**
**dass** der zweite chemische Zustand durch lokalisiertes chemisches Processing in Teilbereichen der Halbleiteroberfläche erzeugt wird.

6. Verfahren nach Anspruch 5,
**dadurch gekennzeichnet,**
**dass** das Processing durch eine gesteuerte Energiequelle (16) erfolgt, die so gesteuert wird, dass der zweite chemischer Zustand so erzeugt wird, dass er einer zu druckenden Bildinformation (12) oder deren Negativ entspricht.

7. Verfahren nach Anspruch 6,
**dadurch gekennzeichnet,**
**dass** die gesteuerte Energiequelle (16) ein Laser, insbesondere ein gepulster Lasers oder eine herkömmliche Energiequelle, wie z. B. eine UV-Lampe ist.

8. Verfahren nach Anspruch 7,
**dadurch gekennzeichnet,**
**dass** der Laser ein Flourlaser mit einer VUV-Wellenlänge von 157 nm ist, oder ein Excimer-Laser mit einer UV-Wellenlänge ≤ 308 nm ist, oder ein Festkörperlaser, wie z. B. Nd: YAG'-Laser, mit einer Wellenlänge ≤ 355 nm.

9. Verfahren nach einem der Absprüche 1 bis 8,
**dadurch gekennzeichnet,**
**dass** die Halbleiteroberfläche amorphes polykristallines oder kristallines Silizium, Germanium oder eine Legierung aus Silizium oder Germanium, insbesondere SiGe, SiC, SiCN ist.

10. Verfahren nach einem der Ansprüche 1 bis 9,
**dadurch gekennzeichnet,**
**dass** der zweite chemische Zustand durch eine lokal begrenzte Änderung der chemischen Struktur im Oberflächenbereich mit einer Dicke von bis zu 5 nm erfolgt.

11. Druckform (10), insbesondere Druckplatte oder Druckzylinder mit einer Halbleiteroberfläche (14), die ein aus hydrophilen und hydrophoben Bereichen bestehendes Muster trägt,
**dadurch gekennzeichnet,**
**dass** die hydrophilen Bereiche chemische Endgruppen in einem ersten chemischen Zustand und die hydrophoben Bereiche chemische Endgruppen in einem zweiten chemischen Zustand aufweisen, wobei der erste chemische Zustand vom zweiten chemischen Zustand verschieden ist.

12. Druckform nach Anspruch 11,
**dadurch gekennzeichnet,**
**dass** die hydrophoben Bereiche einer zu druckenden Bildinformation (22) oder deren Negativ entsprechen.

13. Druckform nach einem der Ansprüche 11 oder 12,
**dadurch gekennzeichnet,**
**dass** die Halbleiteroberfläche amorphes polykristallines oder kristallines Silizium, Germanium oder z. B. eine Legierung aus Silizium oder Germanium (SiGe), insbesondere auch SiC oder SiCN ist.

14. Druckform nach einem der Ansprüche 11 bis 13,
**dadurch gekennzeichnet,**
**dass** der zweiter chemische Zustand bis zu einer Dicke von maximal 5 nm von der Oberfläche in den Halbleiter hinein reicht.

## Claims

1. Method of changing the wetting properties of a printing form (10) with a semiconductor surface (12),
**characterized in**
- **that** the surface of the semiconductor is brought into a first chemical state having a first wetting property; and
- **that** a portion of all areas of the semiconductor surface are brought into a second chemical state having a second wetting property different from the first wetting property by changing the chemical terminal groups of the semiconductor surface.

2. Method according to claim 1,
**characterized in**
**that** the second chemical state is achieved by changing atomic groups of the first atomic layers in the surface region of the semiconductor.

3. Method according to one of claims 1 or 2,
**characterized in**
**that** the first wetting property is hydrophilic and the second wetting property is hydrophobic or that the first wetting property is hydrophobic and the second wetting property is hydrophilic.

4. Method according to one of claims 1 to 3,
**characterized in**
**that** the first chemical state is obtained by a layer removal on the surface of the semiconductor in an atomic dimension, preferably with HF or an ammonium fluoride (AF) solution.

5. Method according to one of claims 1 to 4,
**characterized in**
**that** the second chemical state is generated by localized chemical processing in partial regions of the semiconductor surface.

6. Method according to claim 5,
**characterized in**
**that** the processing is effected by a controlled energy source (16), which is controlled in such a way that the second chemical state is generated to correspond to image information (12) to be printed or to the negative of the latter.

7. Method according to claim 6,
**characterized in**
**that** the controlled energy source (16) is a laser, in particular a pulsed laser or a conventional energy source such as a UV lamp.

8. Method according to claim 7,
**characterized in**
**that** the laser is a fluorine laser having a VUV wavelength of 157 nm or an excimer laser with an UV wavelength ≤ 308 nm or a solid-state laser having a wavelength ≤ 355 nm, such as an Nd: YAG' Laser.

9. Method according to one of claims 1 to 8,
**characterized in**
**that** the semiconductor surface is amorphous polycrystalline or crystalline silicon, germanium or an alloy of silicon and germanium, in particular SiGe, SiC, SiCN.

10. Method according to one of claims 1 to 9,
**characterized in**
**that** the second chemical state is achieved by a locally limited modification in the chemical structure in the surface region with a thickness of up to 5 nm.

11. Printing form (10), in particular printing plate or printing cylinder, with a semiconductor surface (14) carrying a pattern consisting of hydrophilic and hydrophobic regions,
**characterized in**
**that** the hydrophilic regions have chemical terminal groups in a first chemical state and the hydrophobic regions have chemical terminal groups in a second chemical state, the first chemical state differing from the second chemical state.

12. Printing form according to claim 11,
**characterized in**
**that** the hydrophobic regions correspond to image information (22) to be printed or to the negative of the latter.

13. Printing form according to one of claims 11 or 12,
**characterized in**
**that** the semiconductor surface is amorphous polycrystalline or crystalline silicon; germanium or, for example, an alloy of silicon or germanium (SiGe), specifically SiC or SiCN.

14. Printing form according to one of claims 11 to 13,
**characterized in**
**that** the second chemical state extends to a thickness of not more than 5 nm from the surface into the semiconductor.

## Revendications

1. Procédé pour modifier les propriétés de mouillage d'une forme imprimante (10) possédant une surface semi-conductrice (12),
**caractérisé en ce que**
- la surface du semi-conducteur est mise dans un premier état chimique possédant un premier comportement de mouillage,
- une quantité partielle de toutes les zones de la surface semi-conductrice est mise dans un deuxième état chimique possédant une deuxième propriété de mouillage par une modification des groupes terminaux chimiques de la surface semi-conductrice, cette deuxième propriété de mouillage étant différente de la première propriété de mouillage.

2. Procédé selon la revendication 1, **caractérisé en ce que** le deuxième état chimique est obtenu par une modification de groupes d'atomes de premières couches atomiques de la région superficielle du semi-conducteur.

3. Procédé selon une des revendications 1 ou 2, **caractérisé en ce que** la première propriété de mouillage est hydrophile et la deuxième propriété de mouillage est hydrophobe, ou encore la première propriété de mouillage est hydrophobe et la deuxième propriété de mouillage est hydrophile.

4. Procédé selon une des revendications 1 à 3, **caractérisé en ce que** le premier état chimique est produit par une destruction stratiforme à la surface du semi-conducteur, à l'échelle atomique, de préférence au moyen de HF ou d'une solution de fluorure d'ammonium (AF).

5. Procédé selon une des revendications 1 à 4, **caractérisé en ce que** le deuxième état chimique est produit par un traitement chimique localisé dans des régions partielles de la surface semi-conductrice.

6. Procédé selon la revendication 5, **caractérisé en ce que** le traitement est exécuté par une source d'énergie commandée (16) qui est commandée de façon que le deuxième état chimique soit produit de manière à correspondre à une information d'image à imprimer (12) ou à son négatif

7. Procédé selon la revendication 6, **caractérisé en ce que** la source d'énergie commandée (16) est un laser, en particulier un laser pulsé ou une source d'énergie traditionnelle, comme par exemple, une lampe à UV.

8. Procédé selon la revendication 7, **caractérisé en ce que** le laser est un laser au fluor possédant une longueur d'onde VUV de 157 nm ou un laser excimer possédant une longueur d'onde UV de ≤308 nm, ou un laser à corps solide comme, par exemple un laser Nd:YAG possédant une longueur d'onde de ≤355 nm.

9. Procédé selon une des revendications 1 à 8, **caractérisé en ce que** la surface semi-conductrice est du silicium amorphe polycristallin ou cristallin, du germanium ou un alliage de silicium ou de germanium, en particulier SiGe, SiC, SiCN,

10. Procédé selon une des revendications 1 à 9, **caractérisé en ce que** le deuxième état chimique est obtenu par une modification localement limitée de la structure chimique dans la région superficielle d'une épaisseur de jusqu'à 5 nm.

11. Forme imprimante (10), en particulier plaque d'impression ou cylindre d'impression possédant une surface semi-conductrice (14) qui porte un motif composé de régions hydrophiles et hydrophobes, **caractérisé en ce que** les régions hydrophiles contiennent des groupes terminaux chimiques dans un premier état chimique et les régions hydrophobes contiennent des groupes terminaux chimiques dans un deuxième état chimique, le premier état chimique étant différent du deuxième état chimique.

12. Forme imprimante selon la revendication 11, **caractérisée en ce que** les régions hydrophobes correspondent à une information d'image à imprimer (22) ou à son négatif.

13. Forme imprimante selon une des revendications 11 ou 12, **caractérisé en ce que** la surface semi-conductrice est du silicium amorphe polycristallin ou cristallin, du germanium ou, par exemple, un alliage de silicium ou de germanium (SiGe), en particulier aussi SiC ou SiCN.

14. Forme imprimante selon une des revendications 11 à 13, **caractérisé en ce que** le deuxième état chimique s'étend dans le semi-conducteur sur une épaisseur de 5 nm au maximum à partir de la surface.
